## Europäisches Patentamt

## European Patent Office

## Office européen des brevets

(19)

(11) Veröffentlichungsnummer : **0 170 834**
**B1**

(12) # EUROPÄISCHE PATENTSCHRIFT

(45) Veröffentlichungstag der Patentschrift :
30.08.89

(21) Anmeldenummer : 85107413.8

(22) Anmeldetag : 15.06.85

(51) Int. Cl.⁴ : **G 01 R 15/08, F 02 D 41/02**

(54) Verfahren zur Messerfassung in Kraftfahrzeugen.

(30) Priorität : 04.08.84 DE 3428879

(43) Veröffentlichungstag der Anmeldung :
12.02.86 Patentblatt 86/07

(45) Bekanntmachung des Hinweises auf die Patenterteilung : 30.08.89 Patentblatt 89/35

(84) Benannte Vertragsstaaten :
DE FR GB IT

(56) Entgegenhaltungen :
EP–A– 0 097 479
AT–B– 281 189
DE–A– 2 633 136
DE–B– 2 003 924

(73) Patentinhaber : ROBERT BOSCH GMBH
Postfach 50
D-7000 Stuttgart 1 (DE)

(72) Erfinder : Kohler, Rolf, Dipl.-Ing.
Breslauerstrasse 13
D-7141 Schwieberdingen (DE)

EP 0 170 834 B1

## Beschreibung

### Stand der Technik

Die Erfindung geht aus von einem Verfahren zur Meßwerterfassung und Meßwertberechnung nach der Gattung des Hauptanspruchs.

In Kraftfahrzeugen kann es für die Brennkraftmaschinensteuerung bzw. -regelung eine Vielzahl von Größen geben, die sich mittels eines Potentiometers erfassen lassen. Gedacht ist insbesondere an das Erfassen der Drosselklappenposition, der Stellung einer Luftmengenmeßklappe, eines Fahrpedals oder, z. B. der Position der Regelstange bei einer Dieseleinspritzpumpe. Einige dieser Anwendungsbeispiele für potentiometrische Meßwertaufnehmer erfordern eine sehr exakte Einstellung. Bei der Massenware Kraftfahrzeug ist dies jedoch nicht immer problemlos, weil vor allem auch Drifterscheinungen aufgrund des Alters der Anlagen sowie Ungenauigkeiten bei Reparaturen mit berücksichtigt werden müssen.

Werden an die Genauigkeit von Potentiometereinstellungen hohe Anforderungen gestellt, dann ist es üblich, die Einstellung der Schleifer der Potentiometer mittels Feineinstellschrauben zu erreichen. Auf diese Weise läßt sich dann zwar eine momentane Kalibrierung erreichen, die jedoch aufgrund verschiedener Umstände längerfristig zu ungenau ist.

Bekannt ist aus der EP-A-0 097 479 ein « Adjustable process variable transmitter ». Dabei geht es darum, das Ausgangssignal eines Drucksensors in einen Ausgangsstrom mit definierten Eckwerten von 4 und 20 Milliampere umzusetzen. Realisiert wird diese Transformation mit der einmaligen Vorgabe von Extremwerten des Sensors und einer Umrechnung nach der sogenannten Potentiometergleichung. Bei der anfänglichen Festlegung der beiden Eckwerte erhält man zwei Gleichungen mit zwei unbekannten, aus denen dann die einzelnen Größen für die Umrechungsformel gewonnen werden. Liegen diese Gleichungsgrößen einmal fest, dann läßt sich einer Eingangsspannung ein definitiver Ausgangsstrom innerhalb der gewünschten Eckwerte zuordnen.

Die DE-A-3 103 212 offenbart eine « Vorrichtung zum Erfassen der am weitesten geschlossenen Stellung des Drosselventils einer Brennkraftmaschine ». Dazu wird jeweils die Meßspannung erfaßt und im ersten Schritt einer Programmschleife daraufhin abgefragt, ob der momentane Meßwert kleiner ist als der zuvor gespeicherte Minimalwert (Emin). Wird ein gegenüber einem früheren Minimalwert kleinerer Meßwert erfaßt, dann tritt der neue Meßwert an die Stelle des alten gespeicherten Minimalwerts. Dieses Verfahren wird als sogenanntes Lernen eines Grenzwertes bezeichnet.

Es hat sich nun gezeigt, daß die bekannten Verfahren und Vorrichtungen nicht in jedem Fall optimale Ergebnisse zu liefern vermögen.

Aufgabe der Erfindung ist es deshalb, ein Verfahren zur Meßwerterfassung und Meßwertberechnung anzugeben, das optimal arbeitet und längerfristig exakt ist.

### Vorteile der Erfindung

Das erfindungsgemäße Verfahren zur Meßwerterfassung mittels Potentiometer als Meßwertfassungsorgan und Meßwertberechnung in Fahrzeugen mit den Merkmalen des Hauptanspruchs löst die gestellte Aufgabe, in dem durch den fortlaufenden automatischen Abgleich eine gute Langzeitkonstanz erreicht wird.

Weitere Ausgestaltungen und Vorteile der Erfindung ergeben sich in Verbindung mit den Unteransprüchen aus der nachfolgenden Beschreibung eines Ausführungsbeispiels.

### Zeichnung

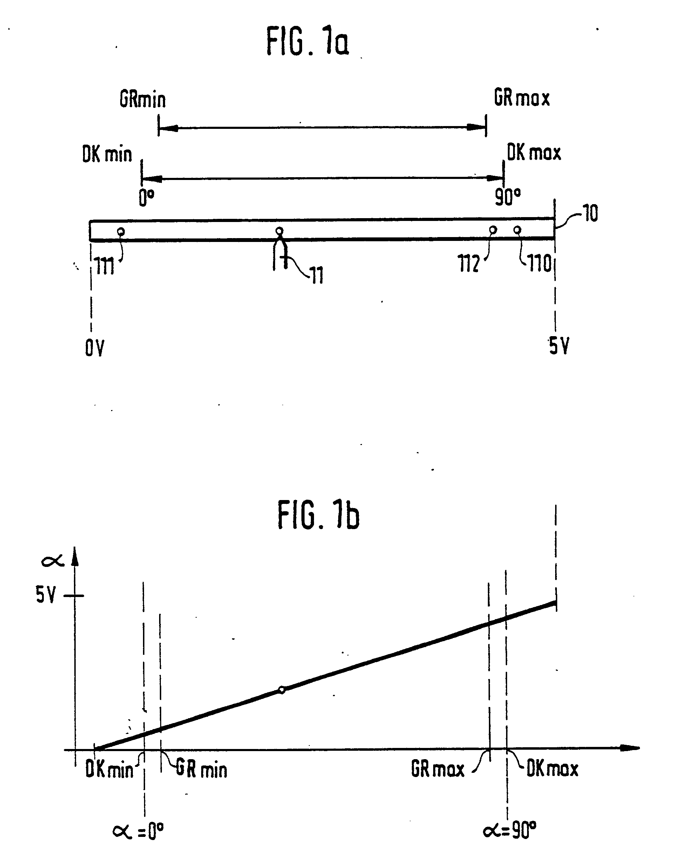

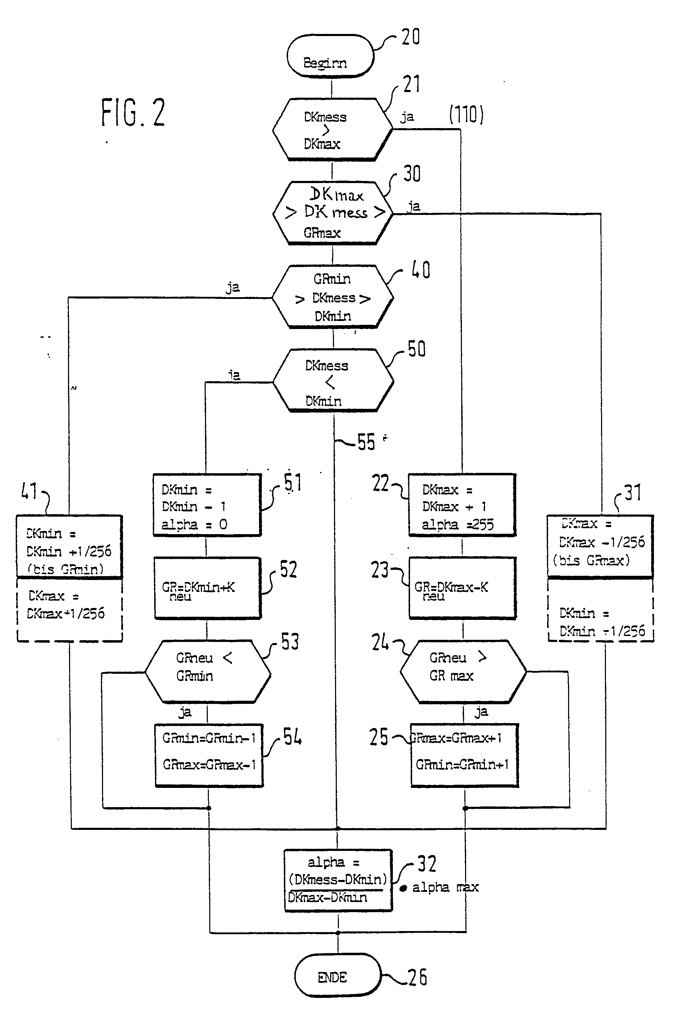

Ein Ausführungsbeispiel ist in der Zeichnung dargestellt und wird im folgenden näher beschrieben und erläutert. Es zeigt Figur 1 die erfindungsgemäße Meßwerterfassung mit einem Potentiometer als Meßerfassungsorgan in der prinzipiellen Darstellung und zur Erläuterung der Erfindung, und Figur 2 ein Flußdiagramm zur rechnergesteuerten Realisierung der erfindungsgemäßen Einrichtung.

### Beschreibung des Ausführungsbeispieles

Das Ausführungsbeispiel betrifft eine erfindungsgemäße Einrichtung zur Meßwerterfassung in einem Kraftfahrzeug in Verbindung mit einer Kraftstoffeinspritzanlage, in der abhängig von der Drosselklappenposition und der Drehzahl der Brennkraftmaschine ein Kraftstoffzumeßsignal gebildet wird. Zwangsläufig steigt mit der Genauigkeit der Meßwerterfassung auch die der Kraftstoffzumessung, was wiederum unmittelbaren Einfluß auf die Güte des Abgases hat.

Figur 1a zeigt eine aus Gründen der Einfachheit linear gezeichnete Schleiferbahn 10 mit einem darauf bewegbaren Schleifer 11. Der Meßbereich des Schleifers 11 wird begrenzt durch DKmin und DKmax und entspricht in einem speziellen Anwendungsfall einem Drosselklappenwinkelbereich von 90°, Wesentlich ist, daß der gesamte Meßbereich des Schleifers innerhalb der Schleiferbahn 10 liegt. Des weiteren ist in Figur 1a ein Meßband mit den Grenzen GRmin und GRmax eingezeichnet. Es besitzt wiederum eine kleinere Ausdehnung als der Meßbereich des Schleifers zwischen DKmin und DKmax.

Figur 1b veranschaulicht Spannungsverhältnisse über der Schleiferbahn bei Annahme eines linearen Verlaufes. Über der ganzen Schleiferbahn fällt dabei die gesamte Betriebsspannung des Potentiometers ab, z. B. 5 Volt. Unterteilt man die Schleiferbahn in Inkremente, dann ergeben sich im Falle von 8 bit über der gesamte Schleiferbahn 0-255 = 256 Inkremente. Der Schleifer des Potentiometers tastet entsprechend der Darstellung von Figur 1b in Verbindung mit Figur 1a lediglich einen Teilbereich der Schleiferbahn ab. Die minimalste Schleiferspannung liegt für eine spezielle Lage des Meßbereichs des Schleifers bei DKmin und die maximale bei DKmax. Entsprechend liegen auch die Grenzwerte GRmin und GRmax für das Meßband. Die einzelne Zuordnung bzw. die Größenverhältnisse der einzelnen Daten sind selbstverständlich auf den jeweiligen Einzelfall abzustimmen und können je nach Anwendungsfall auch sehr kleine Differenzwerte zwischen DKmax und GRmax bzw. DKmin und GRmin haben.

Der Meßbereich des Schleifers zwischen DKmin und DKmax ist in der Regel gegeben und durch mechanische Anschläge bestimmt. Dieser Meßbereich kann jedoch durch Einwirkungen beliebiger Art nach links oder rechts relativ zur Schleiferbahn 10 verschoben werden, so daß dann die absolute Zuordnung von Schleifer zu elektrischem Meßwert nicht mehr stimmt.

Zwei Fälle der Verschiebung der Anschläge sind zu unterscheiden, nämlich eine Verschiebung der Anschläge nach außen sowie eine nach innen.

Bei einer Verschiebung des Anschlags nach außen wird z. B. ein Meßwert DKmeß erfaßt, der der Lage des Punktes 110 von Figur 1a entspricht. Dann wird DKmax ebenfalls nach außen verlegt, DKmin entsprechend nachgezogen, so daß letztlich eine elektrische Verschiebung des Meßbereichs des Schleifers nach rechts vorgenommen wird.

Entsprechend verhält es sich bei einem Meßwert entsprechend dem Punkt 111, der eine Verschiebung des Anschlages nach links symbolisiert und demzufolge elektrisch DKmin und DKmax nach links gerückt wird.

Das Erkennen einer Anschlagsverschiebung jeweils nach außen ist somit relativ unproblematisch und über die Definition neuer elektrischer Grenzen kann entsprechend reagiert werden.

Im Gegensatz dazu läßt sich eine Anschlagverschiebung nach innen nicht so schnell erkennen. Liegt z. B. aufgrund einer Meßbereichsverschiebung der rechte Anschlag des Schleifers im Punkt 112, dann ergibt sich aus dem Meßsignal als solchem nicht ohne weiteres, daß sich der Meßbereich des Schleifers nach links verschoben hat.

Erfindungsgemäß löst man dieses Problem dadurch, daß mit einer relativ großen Zeitkonstante der Grenzwert DKmax schrittweise nach links verlagert wird, sofern er noch rechts eines definierten Grenzwertes GRmax liegt. Zwischen GRmin und GRmax werden die Meßwerte als solche aufgenommen und weitergegeben, während außerhalb des zwischen GRmin und GRmax definierten Meßbandes die Grenzwerte DKmin bzw. DKmax den jeweils gemessenen Wert nachgeführt werden.

Mit der erfindungsgemäßen Einrichtung werden somit elektrische Anschlagsignale laufend Meßwerten nachgeführt, sofern diese Meßwerte selbst in Grenzbereichen, d. h. oberhalb GRmax und unterhalb GRmin liegen. Die Nachführgeschwindigkeit ist dabei klein gegenüber der dynamischen Änderung des Meßwertes.

In einem bestimmten Anwendungsfall hat es sich als zweckmäßig erwiesen, daß die Verschiebegeschwindigkeit von DKmax in Richtung rechts gegenüber der Richtung links um den Faktor 256 zu 1 gewählt wurde.

Der weiteren Erläuterung der erfindungsgemäßen Einrichtung dient das Flußdiagramm von Figur 2. Dabei wurden jeweils die aus Figur 1 bekannten Abkürzungen übernommen.

Das Flußdiagramm von Figur 2 startet mit « Beginn » 20. Es folgt eine Abfrage 21, ob der Meßwert DKmeß größer als ein gespeicherter DKmax Wert ist. Dies entspricht einer Meßstelle 110 von Figur 1. Ist dieser Fall gegeben, dann wird inkrementweise DKmax nach rechts verschoben (Block 22). Gleichzeitig wird der Meßwert auf den vollen Wert gesetzt. Bei 8 bit ist dies der Wert 255. Es schließt sich eine Verschiebung des Meßbandes nach rechts in einem Block 23 an. Der neue absolute Grenzwert ergibt sich dabei aus dem neuen DKmax minus einem Toleranzwert K. Zweckmäßigerweise läßt man die rechte Begrenzung des Meßbandes GRmax ebenfalls inkrementweise nach außen laufen, was mit der Abfrageeinheit 24 in Verbindung mit der Inkrementierung von Block 25 erfolgt. Mit der Verschiebung des Grenzwertes GRmax nach rechts wird gleichzeitig eine Verschiebung des Grenzwertes GRmin nach rechts vorgenommen, was einer Verschiebung des Meßbandes nach rechts entspricht. Es folgt als weiterer Programmschritt das Ende in 26.

Liegt der Meßwert DKmeß im Punkt 112 von Figur 1a, d. h. im Bereich zwischen GRmax und DKmax, dann gibt die Abfrageeinheit 30 ein entsprechendes Signal ab und DKmax sowie DKmin werden entsprechend den Angaben im Block 31 inkrementweise nach links verschoben. Das Meßsignal ergibt sich dann nach Block 32 mittels des Quotienten (DKmeß-DKmin)/(DKmax-DKmin). Auch dieser Programmzweig endet schließlich bei 26.

Dem Flußdiagramm zufolge schließt sich an die Abfrageeinheit 30 die entsprechende Anordnung für die unteren Anschläge an, wie sie in den Abfrageeinheiten 21 und 30 für die rechte Anschlagseite gelten. Die Einheit 40 erfaßt, ob der Meßwert DKmeß kleiner als der Wert GRmin ist. Liegt dies vor, dann erfolgt eine Inkrementierung von DKmin in Block 41 und entsprechend eine Verschiebung des Wertes DKmax nach rechts. Ausgangsseitig ist Block 41 mit 32 verbunden.

Eine Abfrageeinheit 50 stellt fest, ob der Meßwert DKmeß kleiner als DKmin ist. In diesem Fall erfolgt eine Linksverschiebung von DKmin in Block 51, die Bildung eines neuen Grenzwertes DKmin + K als Toleranzwert in Block 52 sowie eine Anpassung der Lage des Meßbandes mit GRmin und GRmax mit der Abfrageeinheit 53 und dem Dekrementierblock 450. Ausgangsseitig von Block 54 folgt auch in diesem Falle das Ende des Programmablaufs 26.

Liegt DKmeß innerhalb des Meßbandes zwischen GRmin und GRmax (Linie 55), dann folgt der Abfrageeinheit 50 unmittelbar die Meßwertberechnungseinheit 32.

Erwähnt sei noch, daß das Meßband zwischen GRmin und GRmax betriebskenngrößenabhängig gewählt sein kann, um die Empfindlichkeit der Nachführung beeinflussen zu können. Außerdem kann der Nachführungsvorgang natürlich auch nur einseitig erfolgen.

Während das obengenannte Ausführungsbeispiel den Einsatz der erfindungsgemäßem Einrichtung im Zusammenhang mit der Erfassung der Drosselklappenposition bei einer Brennkraftmaschine betrifft, so ist die Erfindung doch entsprechend dem Text in der Beschreibungseinleitung überall dort anwendbar, wo eine Messung innerhalb eines verschiebbaren Meßbereichs stattfinden soll.

## Patentansprüche

1. Verfahren zur Meßwerterfassung mittels Potentiometer als Meßwerterfassungsorgan und Meßwertberechnung in Fahrzeugen, insbesondere in Verbindung mit der Brennkraftmaschinensteuerung bzw. -regelung unter Verwendung eines Meßwertes (DKmex), der innerhalb eines Meßbereichs (zwischen DKmin und DKmax) liegen kann, die Berechnung ausgehend vom erfaßten Meßwert und bezogen auf den Meßbereich (DKmax-DKmin) erfolgt und die den Meßbereich begrenzenden Grenzwerte (DKmin, DKmax) speicherbar und lernbar sind, dadurch gekennzeichnet, daß

ein neuer Grenzwert (DKmin, DKmax) nur dann lernbar ist, wenn der Meßwert (DKmeß) außerhalb eines Grenzwertbandes (Meßband zwischen GRmin und GRmax) liegt, wobei das Grenzwertband (Meßband zwischen GRmin und GRmax) innerhalb des Meßbereiches (zwischen DKmin und DKmax) angeordnet ist,

der neue Grenzwert (DKmin, DKmax) durch schrittweise Nachführung an den jeweils aktuellen, außerhalb des Grenzwertbandes (Meßband GRmin, GRmax) liegenden Meßwert (DKmeß) gebildet wird, und

die Nachführung je nach Nachführungsrichtung (entgegen oder in die Richtung des Grenzwertbandes) mit unterschiedlicher Geschwindigkeit erfolgt.

2. Verfahren zur Meßwerterfassung und Meßwertberechnung nach Anspruch 1, dadurch gekennzeichnet, daß mit dem Grenzwert (DKmin, DKmax) der Meßbereich (zwischen DKmin und DKmax) verschoben wird.

3. Verfahren nach Anspruch 1, dadurch gekennzeichnet, daß das Grenzwertband (Meßband zwischen GRmin und GRmax) von Korrekturgrößen abhängig ist.

4. Verfahren nach Anspruch 1, dadurch gekennzeichnet, daß die Nachführgeschwindigkeit gegenüber der dynamischen Änderungen des Meßwertes klein ist.

5. Verfahren nach Anspruch 1, dadurch gekennzeichnet, daß das Verhältnis der Nachführgeschwindigkeiten entgegen in Richtung des Grenzwertbandes (Meßband zwischen GRmin und GRmax) 256 : 1 beträgt.

## Claims

1. Method for measurement value sensing by means of a potentiometer as measured value sensing element and measurement value calculation in vehicles, particularly in conjunction with the control of internal combusion engines, using a measured value (DKmess), which can be within a measurement range (between DKmin and DKmax), the calculation is effected on the basis of the sensed measurement value and referred to the measurement range (DKmax-DKmin) and the limit values (DKmin, DKmax) limiting the measurement range can be stored and learned, characterised in that

a new limit value (DKmin, DKmax) can be learned only if the measured value (DKmess) is outside a limit value band (measurement band between GRmin and GRmax), the limit value band (measurement band between GRmin and GRmax) being arranged inside the measurement range (between DKmin and DKmax),

the new limit value (DKmin, DKmax) is formed by step-bystep tracking of the measured value (DKmess) which is in each case current and is outside the limit value band (measurement band GRmin, GRmax), and

the tracking occurs at a different speed depending on the direction of tracking (opposite to or in the direction of the limit value band).

2. Method for measurement value sensing and measurement value calculation according to Claim 1, characterised in that with the limit value (DKmin, DKmax), the measurement range (between DKmin and DKmax) is displaced.

3. Method according to Claim 1, characterised in that the limit value band (measurement band between GRmin and GRmax) is dependent on correction variables.

4. Method according to Claim 1, characterised in that the tracking speed is low compared with the dynamic changes of the measured value.

5. Method according to Claim 1, characterised in that the ratio of the tracking speeds opposite to or in the direction of the limit value band (measurement band between GRmin and GRmax) is 256 : 1.

## Revendications

1. Procédé pour relever des valeurs de mesure au moyen d'un potentiomètre, en tant qu'organe de détection de ces valeurs de mesure et pour calculer les valeurs de mesure dans des véhicules, notamment en liaison avec la commande ou la régulation du moteur à combustion interne, en utilisant une valeur de mesure (DKmes) qui peut se situer à l'intérieur d'une étendue de mesure (entre DKmin et DKmax), le calcul s'effectuant en partant de la valeur de mesure ainsi relevée et en étant rapportée à l'étendue de mesure (DKmax-DKmin), tandis que les valeurs limites (DKmin, DKmax) délimitant l'étendue de mesure sont susceptibles d'être mémorisées et d'être soumises à un apprentissage, procédé caractérisé en ce que :

une nouvelle valeur limite (DKmin, DKmax) ne peut être soumise à un apprentissage que lorsque la valeur de mesure (DKmes) se situe en dehors d'une bande de valeur limite (bande de mesure entre GRmin et GRmax), cette bande de valeur limite (bande de mesure entre GRmin et GRmax) étant disposée à l'intérieur de l'étendue de mesure (entre DKmin et DKmax),

la nouvelle valeur limite (DKmin, DKmax) est formée par asservissement pas à pas à la valeur de mesure respectivement actuelle (DKmes) se situant en dehors de la bande de valeur limite (bande de mesure entre GRmin et GRmax),

selon le sens de l'asservissement (à contre sens ou bien dans le sens de la bande de valeur limite), cet asservissement s'effectue avec une vitesse différente.

2. Procédé pour relever des valeurs de mesure et pour calculer des valeurs de mesure selon la revendication 1, caractérisé en ce que, avec la valeur limite (DKmin, DKmax) l'étendue de mesure (entre DKmin et DKmax) est décalée.

3. Procédé selon la revendication 1, caractérisé en ce que la bande de valeur limite (bande de mesure entre GRmin et GRmax) dépend de grandeurs de correction.

4. Procédé selon la revendication 1, caractérisé en ce que la vitesse d'asservissement est faible par rapport aux modifications dynamiques de la valeur de mesure.

5. Procédé selon la revendication 1, caractérisé en ce que le rapport des vitesses d'asservissement à contre sens ou dans le sens de la bande de valeur limite (bande de mesure entre GRmin et GRmax) est de : 256 : 1.

# FIG. 1a

# FIG. 1b

FIG. 2

20 — Beginn

21 — DKmess > DKmax — ja (110)

30 — DKmax > DKmess > GRmax — ja

40 — GRmin > DKmess > DKmin — ja

50 — DKmess < DKmin — ja

55

41 — DKmin = DKmin +1/256 (bis GRmin) / DKmax = DKmax +1/256

51 — DKmin = DKmin − 1 alpha = 0

52 — GR=DKmin+K neu

53 — GRneu < GRmin — ja

54 — GRmin=GRmin−1 GRmax=GRmax−1

22 — DKmax = DKmax + 1 alpha =255

23 — GR=DKmax−K neu

24 — GRneu > GRmax — ja

25 — GRmax=GRmax+1 GRmin=GRmin+1

31 — DKmax = DKmax −1/256 (bis GRmax) / DKmin = DKmin −1/256

32 — alpha = (DKmess−DKmin) / DKmax−DKmin • alpha max

26 — ENDE